# EUROPEAN PATENT SPECIFICATION

(11) **EP 2 490 267 B1**
(45) Date of publication and mention of the grant of the patent: **27.03.2019**
(21) Application number: 10823096.2
(22) Date of filing: 14.10.2010
(51) Int. Cl.: H01L 31/05, H01L 25/04, H01L 31/068, H01L 31/043

(54) **PHOTOVOLTAIC DEVICE AND PHOTOVOLTAIC PANEL**
PHOTOVOLTAIKVORRICHTUNG UND PHOTOVOLTAIKTAFEL
DISPOSITIF PHOTOVOLTAÏQUE ET PANNEAU PHOTOVOLTAÏQUE

(30) Priority: 14.10.2009 ES 200930844
(43) Date of publication of application: 22.08.2012
(73) Proprietor: Universidad Del Pais Vasco Euskal Herriko Unibertsitatea, 48940 Leioa (Vizcaya) (ES)
(72) Inventor: JIMENO CUESTA, Juan, Carlos, E-48940 Leioa (Vizcaya) (ES); LUQUE LOPEZ, Antonio, E-48940 Leioa (Vizcaya) (ES); RECART BARAÑANO, Federico, E-48940 Leioa (Vizcaya) (ES); LAGO AURREKOETXEA, Rosa, E-48940 Leioa (Vizcaya) (ES); GUTIERREZ SERRANO, Ruben, E-48940 Leioa (Vizcaya) (ES); VARNER, Kenneth, E-48940 Leioa (Vizcaya) (ES); IKARAN SALEGI, Carmen, E-48940 Leioa (Vizcaya) (ES); HERNANDO BRIONGOS, Fernando, E-48940 Leioa (Vizcaya) (ES); SAENZ NOVALES, María, José, E-48940 Leioa (Vizcaya) (ES); EZQUERRA VENTOSA, Joseba, E-48940 Leioa (Vizcaya) (ES); RODRIGUEZ CUESTA, Maria, Velia, E-48940 Leioa (Vizcaya) (ES); MARTINEZ SANTOS, Víctor, E-48940 Leioa (Vizcaya) (ES); URIARTE DEL RIO, Susana, E-48940 Leioa (Vizcaya) (ES); FANO LESTON, Vanesa, E-48940 Leioa (Vizcaya) (ES); AZKONA ESTEFANIA, Nekane, E-48940 Leioa (Vizcaya) (ES); CERECEDA MORIS, Eneko, E-48940 Leioa (Vizcaya) (ES); MONTALBAN FLOREZ, Cristina, E-48940 Leioa (Vizcaya) (ES); HOCES FERNANDEZ, Itziar, E-48940 Leioa (Vizcaya) (ES); PEREZ MANSANO, Lourdes, E-48940 Leioa (Vizcaya) (ES); OTAEGI AIZPEOLEA, Aloña, E-48940 LEIOA (Vizcaya) (ES); MARTIN REAL, Jorge, E-48940 Leioa (Vizcaya) (ES); FREIRE VELASCO, Iratxe, E-48940 Leioa (Vizcaya) (ES)
(74) Representative: Carpintero Lopez, Francisco
(86) International application number: PCT/ES2010/070661
(87) International publication number: WO 2011/045462

(56) References cited:
- WO-A2-02/091482
- US-A- 4 617 420
- US-A- 5 261 969
- US-A- 5 261 969
- US-A1- 2007 137 698
- "Triple-junction amorphous silicon alloy solar cell with 14.6% initial and 13.0% stable conversion efficiencies", APPLIED PHYSICS LETTERS, AIP, AMERICAN INSTITUTE OF PHYSICS, MELVILLE, NY, US, vol. 70, no. 22, 2 June 1997 (1997-06-02), pages 2975-2977, XP012017968, ISSN: 0003-6951, DOI: 10.1063/1.118761

## Description

### Technical Field of the Invention

The invention is encompassed in the field of photovoltaic solar energy and, more specifically, in the field of "tandem" photovoltaic devices, i.e., devices comprising a plurality of layers having energy band gaps with a different width.

### Background of the Invention

Crystalline silicon solar cells have dominated the market of the photovoltaic sector from the start and currently make up between 80 and 90% of it. The reasons for the success of this technology are based on the abundance and relative low cost of silicon as a base material for cell manufacturing, a reasonable efficiency and a very stable and relatively simple manufacturing technology. The photovoltaic modules made with silicon cells are stable over long periods of time, and both the materials and the processes used in their manufacturing are very environmental friendly.

Solar cells manufactured industrially for inclusion in flat panel photovoltaic solar modules typically have light to electricity conversion efficiencies of the order of 15 to 18%, depending on the quality of the starting material used and the complexity of the solar cell manufacturing process. In 1999 solar cells with efficiencies of up to 24.7% were obtained in a laboratory in the University of New South Wales, UNSW, Australia, using the best substrates and complex manufacturing processes in a very careful manner. The use of the solar cells under concentrated light allows increasing the efficiency of solar cells, basically because although the operating current increases proportionally to the level of concentration, the voltage at which the cell operates also tends to increase slightly, causing the power generated (IxV) to increase more than the level of incident light. For concentrated light, the American company AMONIX has achieved an efficiency of 27.6% at 92x concentration with a back contact cell developed by Stanford University, USA.

Efficiency is a key parameter in reducing the cost of photovoltaic solar energy. Obtaining more energy from the same photovoltaic collector surface means reducing the costs associated with the use of raw materials, glass and encapsulation, supports, wiring, land, installation and maintenance, etc.

The cells or devices called tandem or multi-junction devices are one of the best candidates for making highly efficient photovoltaic arrays. In these devices different layers or solar cells made of different semiconductor materials having band gap with different widths are stacked. The width of the band gap of a semiconductor determines the minimum energy of the photons which can be absorbed by that material, which will appear to be transparent for less energetic photons. The width of the band gap is also linked to the voltage at which the solar cell can operate, such that greater voltages tend to be obtained as this width of the band gap increases. In tandem cells or devices the cell with a wider band gap is located in the upper part of the structure, it is exposed directly to the rays of the sun, while the cell with a narrower band gap is located in the lower part. The upper cell thus absorbs the more energetic photons falling on the next structure, being transparent to the rest. The process is repeated until only those photons the energy of which is less than the narrowest band gap existing in the tandem array remain. Each cell is connected to the closest upper and lower cells the negative terminal of one being joined with the positive terminal of the other and vice versa. Each solar cell thus works at a different voltage, the total voltage of the tandem cell being the sum of all of them, but they must all work at the same current, since it crosses the entire tandem structure. This situation makes the tandem cells very sensitive to the incident light spectrum and also to the manufacturing process itself, since the cell producing less photocurrent will limit the current delivered by the entire array.

Tandem cells have been manufactured based on very different materials, such as those based on amorphous silicon and others on II-VI or I-III-VI materials, such as, CdSe/CIGS, for example. But the most developed materials are those which are based on III-V semiconductors. Cells with efficiencies greater than 40% have recently been made with these materials. Conversion efficiencies of the order of 50% are expected for structures with 4 levels of semiconductor, the theoretical limit being above 60% for structures with an unlimited number of solar cell layers.

More specifically, the patent application US5261969A relates to a monolithic, multicell, voltage-matched photovoltaic cell and a method for manufacture and, particularly, to a GaAs/Cu InSe₂ monolithic tandem cell.

One drawback of such devices is their great complexity. For example, a Fraunhofer-ISE cell with an efficiency of 41.1% at 454 suns concentration, contains a total of 19 semiconductor layers. Furthermore, such devices frequently use germanium as a support material, making them very expensive and can only be used in a cost effective manner in space applications or in land applications with concentrated light. In this sense there are attempts to replace the lower layer of germanium with a much more economical layer of silicon.

The development from the current silicon cells to other more efficient cells based on the tandem structure described above is not simple. Silicon cells are capable of producing a photogenerated current in the gap of 34 to 41 mA/cm² of material. Below 1.1 eV of energy, which the silicon is capable of absorbing, only those of the order of 20 mA/cm² which could be converted into electricity at reasonable voltage values remain in the solar spectrum. This means that the design of a tandem cell with silicon and germanium in its last two levels would require the use of one or two more cells in the upper part of the tandem structure, capable of removing the 14 to 21 mA/cm² of photons which cannot be harnessed in this structure from the silicon cell and converting them into electricity at other greater voltages.

The use of the conventional tandem cell structure with in series connection in all levels therefore requires complex structures to substantially improve the electric features of current silicon cells.

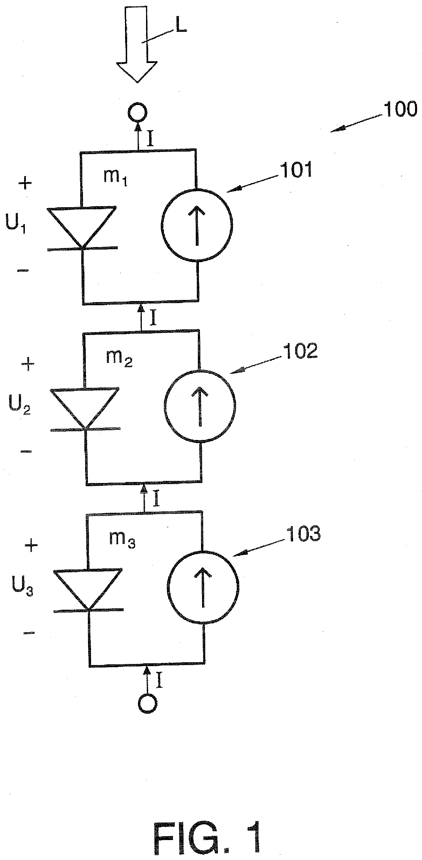

Figure 1 shows an example of an equivalent circuit of a tandem photovoltaic cell structure according to the state of the art. It can be considered that what is called a tandem cell 100 is in actual fact a photovoltaic device made up of a plurality of solar cells 101-103 (sometimes called "sub-cells", to tell them apart from the "global" cell 100) connected in series and configured to receive sunlight L. Each of said solar cells corresponds to a layer of the structure of the device, and the cells/layers are overlapped such that at a first end (which is usually referred to as "upper end", since it is the end which, when the device is in use, is positioned to receive the sunlight first) there is a first one 101 of said layers, and at a second end, which is usually referred to as the "lower end", there is a last one 103 of said layers, there being able to be one or more intermediate layers 102. Each solar cell (101, 102, 103) therefore corresponds to one of the layers of the structure, and the cells (layers) are connected in series, as shown in Figure 1.

Each cell or layer is made of a specific material (or a combination of materials) (in Figure 1, m1, m2, m3) and is configured to have a specific band gap, varying between the different layers. The upper layer 101 has a wider band gap (for example, in a typical case, of the order of 1.7 eV), the next layer 102 has a narrower band gap (for example, of 1.2 eV), etc., such that the narrowest band gap (for example, of 0.7 eV) is that of the lower layer 103. Therefore, as is known, when sunlight L falls on the structure, the photons cross the different gaps from top to bottom and are "absorbed" by the gaps according to the energy of the photons., The upper solar cell 101 thus absorbs the photons the energy of which exceeds the width of its band gap (and produces an energy corresponding to said gap, at least the difference between the energy of the photon and the width of the band gap of the layer "being lost"), while the rest of the photons pass to the next layer, etc. To maximise the efficiency of the photovoltaic device, it is therefore necessary to, on one hand configure it such that it has a suitable number of layers and, on the other hand, assure that the distribution of the widths of the band gaps of said layers is suitable depending on the sunlight energy spectrum.

A problem resulting from the in series connection of the photovoltaic or solar cells is that, while each cell operates at a voltage (U1, U2, U3) which is a function of, among other things, the width of its band gap and of the light intensity and spectrum, the current (I) is the same across all the cells, such that the cell producing the least current limits the total current of the device, such that if, for example, one of the solar cells 101 and 102 is capable of producing a very high current by absorbing a lot of solar energy, its capacity to convert it into electric energy can be limited by the current produced by another one of the layers, for example, the lower layer 103. This implies an additional difficulty at the time of designing and producing "tandem" photovoltaic devices: not only is achieving a structure, the band gap distribution of which is optimum, necessary (or at least good) depending on the solar energy spectrum, but designing the device so that none of the layers or photovoltaic cells excessively limit the performance of another one of the layers is also important. Not only does this make designing difficult, but it can also increase the cost of the device, since the use of a large number of layers and/or layers of costly materials may be necessary.

Trupke et al., "Improved spectral robustness of triple tandem solar cells by combined series/parallel interconnection", Journal of Applied Physics, Vol. 96, No. 4, 15/8/2004*,* describes an attempt to overcome the problem involving the fact that the current crossing each layer or cell of the tandem device must be the same. The problems which this limitation in terms of the current involve in a three layer structure (known as *"triple tandem solar cell'*) are described, and connecting two of the layers, those having the narrower band gaps (namely, the two lower layers), in series to one another, and then connecting these two layers in parallel with a layer with a wider band gap (namely, the upper layer) is proposed as the solution. Therefore the lower layers do not limit the current produced by the upper layer, while at the same time an acceptable voltage (for example, the sum of the voltage of the two lower layers) is achieved. It is indicated that increasing the efficiency of the device is anticipated with this arrangement, although it is also mentioned that there may be some technical problems which must be solved.

It is likely that the structure proposed by *Trupke et al.* effectively increases efficiency. However, it also seems to have certain limitations. Firstly, it requires at least three layers (two which must be connected in series, and the third one, the upper layer). On the other hand, since it is necessary to obtain a suitable voltage with which the device operates, it is also necessary to choose the materials for the different layers properly for the purpose of optimising not only the currents produced, but also the voltage, something which imposes a limitation to the designer of the structure in terms of, for example, the choice of materials. It can also be that the interconnection between layers may involve certain difficulties due to the particular combination of parallel and series connections.

### Description of the Invention

It has therefore been considered that providing an alternative structure which could also serve to increase efficiency with respect to conventional tandem devices, but which offers new design possibilities of the device, for example, by not requiring three layers, by not requiring in series connection between layers, and/or by allowing new combinations of materials while at the same time achieving suitable currents and voltages would be of great interest.

A first aspect of the invention relates to a photovoltaic device, comprising a plurality of layers configured to convert light (L) into electric energy, each layer comprising at least one solar cell, each layer being configured such that it has a band gap with a predetermined width, the width of the band gap of each layer being different from the width of the band gap of the other layers. According to the invention, at least one of said layers comprises at least two solar cells connected in series, said solar cells connected in series having band gaps with the same width. The layers are also connected to one another in parallel, such that the voltage on each layer is the same.

Given that the layers are connected in parallel, the current produced by one layer is not limited by the current produced by the other layers, something which facilitates the design of an efficient device, with, for example, comparatively few layers and/or less costly materials.

The case of a tandem device in which one of the layers is a crystalline silicon cell (this cell could be made from a silicon substrate, which would be the mechanical support of the entire structure, which would reduce the overall device cost with respect to others using, for example, germanium or another material as a support) can be considered by way of example. A silicon solar cell can produce current of the order of 40 milliamperes per square centimetre of surface exposed to light in standard illumination conditions ("one sun"). If another solar cell made from a material with a narrower band gap, germanium for example, was added in the lower part of the silicon cell and a conventional tandem structure was used, the overall device could produce an electric current less than 17 milliamperes per square centimetre. This is due to the fact that the fraction of the solar spectrum which is capable of being absorbed by a germanium cell but not by a silicon cell, through which it would have already been filtered, is in this range of values. The excess current produced by the silicon cell, the remaining 23 milliamperes per square centimetre, would therefore be wasted. For an efficient embodiment of this structure it would be necessary to include at the upper end another material capable of converting at least another 17 milliamperes per square centimetre corresponding to the more energetic photons capable of being absorbed by a material with a wider band width into electricity, producing a voltage greater than that of the silicon cell. The assembly could start with a material with a band gap width of 1.7-1.8 eV, followed by silicon and lastly germanium. This entire structure would become more complicated with all the additional layers placed between each solar cell and which are necessary for the correct operation of the tandem cell according to the state of the art. In order for this structure to be efficient a minimum of three layers would be needed if the two lower ones are of silicon and germanium.

This problem is solved with the invention. According to the invention the layer of germanium is added in the lower part of the silicon cell, but by dividing the layer of germanium into two cells of identical or similar areas (such that each of these two cells produces a current approximately equal to that produced by the other), connected in series to one another. The 40 milliamperes corresponding to the silicon cell plus another 8.5 milliamperes of each germanium cell could be obtained per square centimetre of the new device, a total current of 48.5 milliamperes which involves a gain greater than 20% in relative value with respect to the original silicon cell being obtained.

With the structure according to the state of the art (i.e., according to the concept illustrated in Figure 1) the current flowing through each layer or individual cell is kept constant and the voltages produced by each cell are added. The current, which is the common parameter, is limited by that structure providing less current that the rest. With the structure according to the invention, the parameter common to all the layers is the voltage, obtained as the sum of the voltages of all the solar cells which are joined in series in the layer producing less voltage. However, the total current in the device is obtained as the sum of the currents of all the layers. In the device according to the invention, it is the voltage of the worse layer which limits the operation of the entire device. With respect to the level of illumination, be it referring to the entire spectrum comprised by sunlight or to each of the sub-spectrums capable of being absorbed by each semiconductor layer, the current has a linear behaviour, therefore being very sensitive to variations of the level of light or to changes of the spectral components of light. However, the voltage at which the different cells operate varies logarithmically with the level of illumination, which makes this parameter, the voltage, to have a low sensitivity with respect to the illumination. This quality turns the structure of the invention into a much more robust structure than the conventional one due to its greater independence in terms of its operating features with respect to the possible variations in the level of light, fundamentally to those altering the spectral distribution of light.

One of the layers is of silicon, more specifically of crystalline silicon. In other words, the device comprises silicon solar cells, something which reduces the cost.

Another one of the layers is of a material comprising germanium. It has been proven that due to its characteristics, including the width of its band gap, the combination of a layer of silicon and a layer based on germanium -for example, based substantially on germanium or on germanium-silicon- can represent a suitable balance between cost and efficiency.

The layer of silicon comprises a solar cell with an upper face and a lower face, and two (2) solar cells of the material comprising germanium connected in series can be arranged in said lower face. It has been proven that the 1:2 ratio between the silicon cells and the germanium or germanium-silicon cells can be optimum: it allows producing an acceptable current at an acceptable voltage; if only one germanium cell had been used per silicon cell, the germanium cell would produce more current - by having a larger surface- but the voltage would fall, something which would negatively affect the contribution of the silicon cell to the total power produced by the device, resulting in a worse efficiency than that achieved with the 1:2 ratio.

According to a possible embodiment of the invention, a second one of the layers can be a layer of silicon comprising a plurality of second solar cells connected in series, a third one of the layers can be a layer of a material comprising germanium, comprising said third one of the layers a plurality of third solar cells connected in series, such that at least two of the third solar cells connected in series are arranged in a lower face of each of the second solar cells. An additional layer, namely, a first one of the layers, can also be arranged on an upper face of the second one of the layers and comprises at least one solar cell having a band gap wider than the silicon band gap.

The material comprising germanium is germanium or germanium-silicon.

The device of the invention comprises a layer of silicon, which is a support layer for the plurality of layers. Given that the support layer has to perform the function of a "support", it generally comprises more material than the other layers, such that being able to manufacture it from silicon may imply a cost reduction.

According to the invention, at least one of the layers comprises at least one silicon solar cell with contacts in the lower face, at least two germanium or germanium-silicon solar cells connected in series being deposited on said lower face.

Another aspect of the invention relates to a photovoltaic panel or solar panel, comprising a plurality of the photovoltaic devices according to the invention.

### Description of the Drawings

To complement the description and for the purpose of aiding to better understand the features of the invention according to a practical preferred embodiment thereof, a set of drawings is attached as an integral part of the description, in which the following has been depicted with an illustrative and nonlimiting character:
Figure 1 shows an example of an equivalent circuit of a tandem photovoltaic device structure according to the state of the art.
Figure 2 shows an example of an equivalent circuit of a tandem photovoltaic device structure according to a possible embodiment of the present invention.
Figure 3 shows the different absorption coefficient of silicon and of germanium.
Figure 4 shows the different parts of the solar spectrum which would be absorbed by each of the solar cells.
Figure 5 shows a schematic perspective view of a silicon photovoltaic back contact cell.
Figure 6 shows a schematic perspective view of the same silicon photovoltaic cell with two germanium cells overlapping in its lower face.
Figure 7 shows a cross-section of a structure similar to that of Figure 6.

### Preferred Embodiments of the Invention

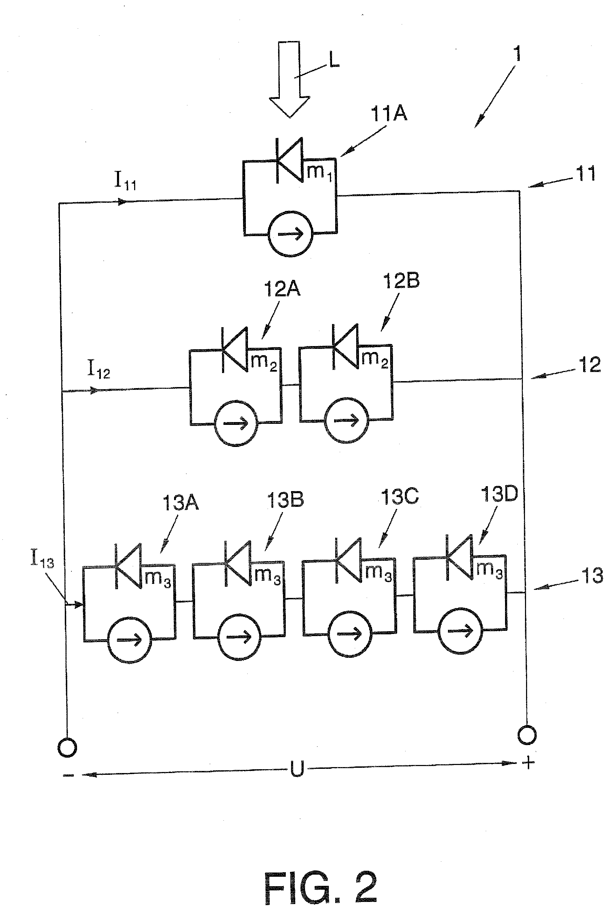

Figure 2 shows how a photovoltaic device according to the invention can comprise two or more layers (11, 12, 13) configured to convert light L into electric energy. Each layer comprises at least one solar cell, and each layer is configured such that it has a band gap with a predetermined width, the width of the band gap of each layer being different from the width of the band gap of the other layers. At least one of the layers (12, 13) comprises at least two solar cells (12A, 12B; 13A, 13B, 13C, 13D) connected in series, and the layers are connected to one another in parallel, such that the voltage U on each layer (11, 12, 13) is the same. As can be seen, a different current (I11, I12, I13) flows through each layer, such that the device produces a total current which is the sum (I₁₁+I₁₂+I₁₃) of the currents produced by each layer.

In a typical embodiment, the device can comprise two layers, for example, a layer of crystalline silicon with one or more solar cells in series, and another layer of germanium or silicon-germanium, arranged on the lower face of the above layer, such that there are two or more germanium cells connected in series on the "lower" surface of each silicon solar cell. It is possible that another layer with a band gap greater than that of silicon (for example, a band gap greater than 2 eV) is deposited on the layer of silicon, in which case there can be two or more silicon solar cells arranged in each solar cell of the upper layer. According to the invention, the support of the structure is the layer of silicon -among other things, because it is a relatively inexpensive material, so the fact that it makes up a large part of the total material of the device can reduce the cost thereof-, and there is a layer of germanium or of silicon-germanium arranged on the lower surface of the layer of silicon, according to the described structure, i.e., with two or more germanium or germanium-silicon photovoltaic cells arranged on the lower face of each silicon photovoltaic cell, something which provides a good efficiency at an acceptable cost. Logically, this structure can be completed with additional layers, increasing the total efficiency of the device but also, as is logical, increasing its complexity and in many cases, its cost.

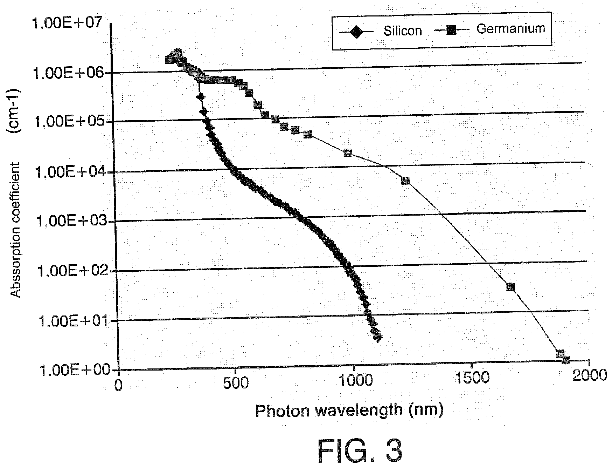

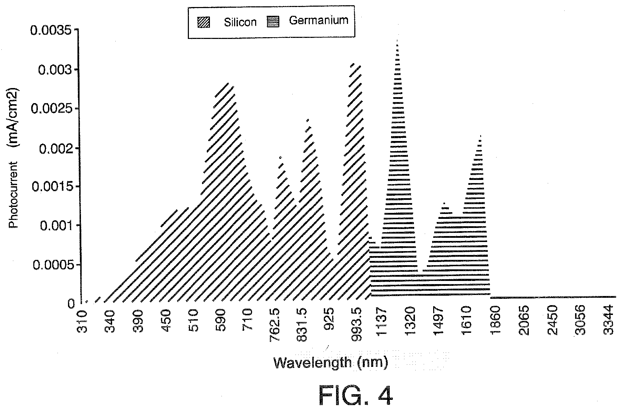

As has been indicated, for the cells with a gap width less than that of silicon, germanium or silicon-germanium can be used, the band gap width of which can be modulated in the range of 0.65 to 1.1 eV depending both on the silicon to germanium ratio and on the stress of the crystal lattice. Figure 3 shows the different absorption coefficients of silicon and of germanium. Above 1000 nm almost all the sunlight is absorbed in the germanium or silicon-germanium cells, small thicknesses of this cell, less than 5 micrometers, being sufficient for collecting most of the infrared spectrum. Figure 4 shows the different parts of the solar spectrum which would be absorbed by each of the solar cells.

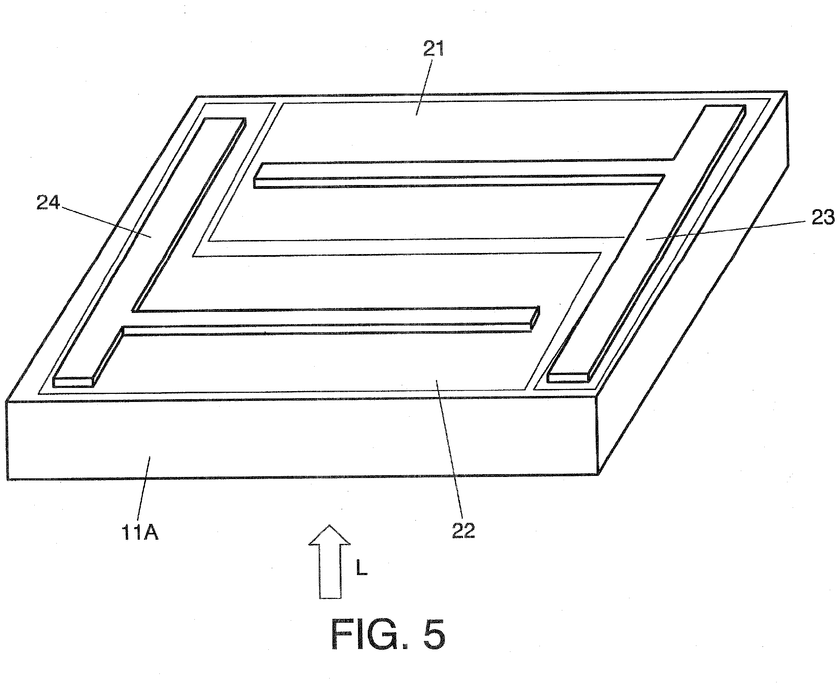

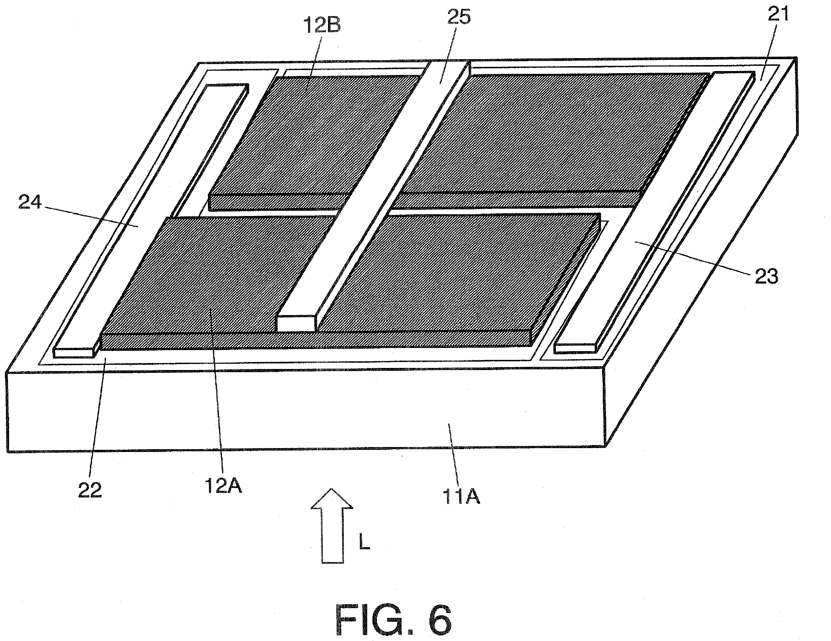

In the case that the silicon cell is a back contact cell, both the structure of the cell and its manufacturing are simple. Figure 5 schematically shows a silicon photovoltaic cell 11A in perspective view and with its lower face (i.e., the face which does not receive sunlight L) upwards. The positive emitter 21, the negative emitter 22, the positive electrode 23 and the negative electrode 24 can be seen. Figure 6 shows the two layer structure, in which two germanium (or germanium-silicon) photovoltaic cells 12A and 12B, connected in series through the electrode 25 and connected in parallel with the silicon photovoltaic cell 11A through the back contacts 23 and 24 have been overlapped on the layer of silicon, which can form the support of the structure.

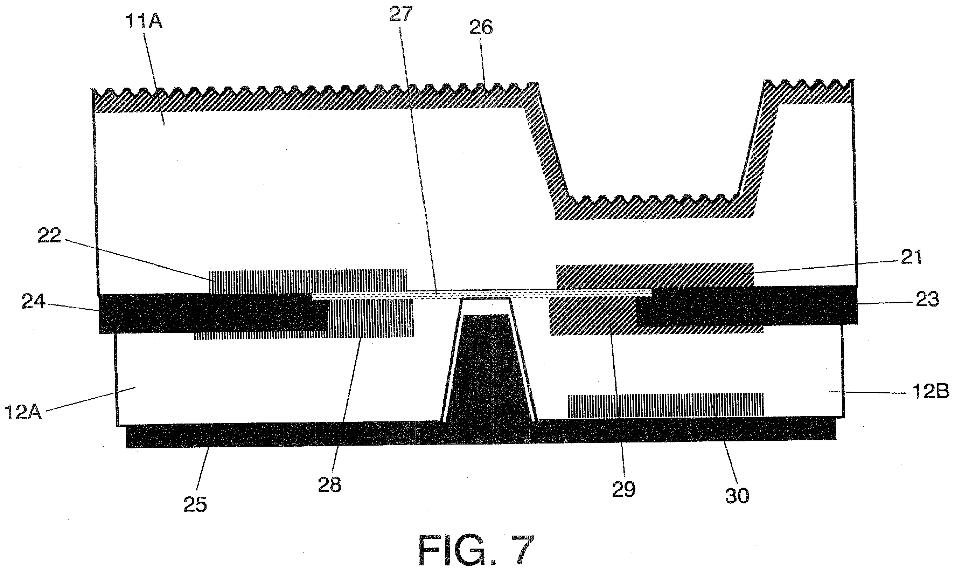

Figure 7 schematically illustrates a cross-section of a structure similar to that of Figure 6, where similar elements have the same numerical references. The upper part of the photovoltaic cell has a particular configuration typical of the TWT cells described in WO-A-2006/051132, but could be any other: it is not an essential feature of the invention. The front emitter 26 (n or p-type) and the positive emitter 21 and negative emitter 22, as well as the corresponding negative emitter 28 and positive emitter 29 of the germanium cells, which are connected in series through the electrode 25 can be seen.

In other words, the layer of germanium is divided into small portions each covering the n-type or the p-type region corresponding to the interdigitated structure of the rear face of the silicon cell. The n-type and p-type emitters of the front faces of the n⁺p and p⁺p cells, or n⁺n and p⁺n cells if the germanium is n-type doped germanium, could be formed from those in the rear face of the silicon cell by diffusion thereof. An emitter 30 may be necessary in the rear face of one of the germanium cells in order to complete the p⁺pn⁺ or n⁺np⁺ structure, depending on the type of germanium deposited. A metal layer 25 is deposited joining the rear faces of both germanium cells in order to connect the n⁺p and p⁺pn⁺ structures, or n⁺np⁺ and p⁺n structures in series if the germanium is n-type doped germanium. Lastly an isolator 27 may be necessary between the silicon and germanium cells in order to separate the Fermi pseudo-levels of both structures.

In the case of a three level cell semiconductor layers could be deposited on the front face of the silicon cell. These layers could have a width of the band gap of the order of 2 eV or greater, for example, 1.7 eV or greater, and its working voltage could be, in a typical case, between 1 and 1.2 volts. The silicon cell, substrate of the germanium one, could be divided into two and each half must be connected in series. The resulting cell must be connected in parallel with the upper cell. In other words, it would correspond with the structure illustrated in Figure 2, the cells of the layer 12 being silicon cells and those of the layer 13 being germanium or germanium-silicon cells. It would also correspond with that of Figure 6, the cells 12A and 12B being silicon cells and the cell 11A being the cell of the upper layer (and the germanium cells which would overlap the silicon cells not being seen).

For a two level structure, the first level of silicon and the second level of germanium or of silicon-germanium, the germanium cell could collect up to 17 mA/cm², which cannot be harnessed by the silicon cell. Since this cell is divided into two halves, then connected in series, the germanium structure could collect up to 8.5 mA/cm² and easily above 6 mA/cm². These figures entail an improvement of 12 to 20% with respect to the silicon cell used as a support. Taking into account that it is possible to manufacture silicon cells with efficiencies of up to 24.7% measured at 1 sun, the new two level structure could represent a technologically attainable efficiency of 27 to 30% in the gap. For a three level structure, around 10 mA/cm² of those previously collected by the silicon cell at double the voltage could be obtained. The attainable efficiency for this structure would be 32 to 36% in the gap.

The basic two level structure, namely an upper level which is a silicon back contact cell, and a lower level which is an array of two germanium cells in series, as can be seen in, for example, Figures 6 and 7 is considered below by way of example.

The upper silicon cell can have an interdigitated rear structure , which can be of the IBC or PCSC or EWT or TWT type (see WO-A-2006/051132) or any another similar one, the manufacturing process of which is well described in the literature. This cell may already be provided with the metal fingers 23 and 24, since these are at least partially buried under the layer of germanium deposited. A layer of germanium with a thickness between 1 and 5 micrometers can be deposited on the rear part of the cell. This layer can be deposited by chemical vapour deposition, CVD, from GeH₄, or other chlorinated compounds, such as GeH₂Cl₂, reacting them with SiH₄ or SiH₂Cl₂ in a hydrogen environment, generally at low pressure. Due to the large, 4.2%, lattice constant difference between the silicon and the germanium it may be necessary to use special techniques in order to prevent the appearance of dislocations when, for sufficient thicknesses, the lattice of the germanium relaxes to its equilibrium size. A common technique consist of depositing a thin layer of Ge at temperatures in the range of 300 to 350°, followed by another already thick layer deposited above 600°, finishing the process by annealing the entire structure. The layer of germanium can be deposited on the entire rear face of the wafer and subsequently drafted by means of chemical etching or by laser ablation, or it can also be selectively deposited using a thin layer of SiGe as a seed. In this case the deposition process in two temperatures described above could be prevented.

An oxidation process in an oxygen or water vapour environment could create the layer of silicon oxide necessary for isolating the silicon and germanium cells either during the deposition of the layer of germanium, or at the end thereof by using this chemical reaction:

Ge + O₂ → GeO₂

If + GeO₂ → SiO₂ +Ge

Technology for epitaxial germanium deposition on thin layers of silicon oxide can also be found in the literature. Currently there is a great interest in germanium and silicon-germanium deposition technologies for manufacturing high speed bipolar transistors and for photodetectors, therefore there is a lot of technology developed for this purpose.

At least one of the two resulting germanium cells may need diffusion in its rear face, a p-type if the germanium deposited is n-type or vice versa. This diffusion can be performed either by means of conventional masking, window openings and oven diffusion techniques or by means of selective doping using screen printing deposition of the dopant. Metalization, performed either in high vacuum or by screen printing, will electrically join both germanium structures.

In this text, the word "comprises" and its variants (such as "comprising", etc.) must not be interpreted in an excluding manner, i.e., they do not exclude the possibility that what has been described includes other elements, steps etc.

On the other hand, the invention is not limited to the specific embodiments which have been described but also encompasses, for example, the variants which can be made by a person having ordinary skill in the art (for example, in terms of the choice of materials, dimensions, components, configuration, etc.), within the scope of the invention, which is defined in the appended claims.

## Claims

1. Photovoltaic device comprising a plurality of layers (11, 12, 13) configured to convert light (L) into electric energy, each layer (11, 12, 13) comprising at least one solar cell (11A; 12A, 12B; 13A, 13B, 13C, 13D), each layer (11, 12, 13) being configured such that it has a band gap with a predetermined width, the width of the band gap of each layer (11, 12, 13) being different from the width of the band gap of the other layers (11, 12, 13), wherein at least one of said layers (12, 13) comprises at least two solar cells (12A, 12B; 13A, 13B, 13C, 13D) connected in series, said solar cells connected in series having band gaps with the same width; and wherein the layers (11, 12, 13) are connected to one another in parallel, such that the voltage (U) on each layer (11, 12, 13) is the same,
**characterised in that** at least one of said layers (11) is a layer of silicon which is a support layer for the plurality of layers (11, 12, 13), said layer (11) of silicon comprising:
- at least one silicon solar cell (11A) with an upper face and a lower face, said layer (11) of silicon comprising back contacts (23, 24) in the lower face, wherein another one of said layers (12) comprises either two germanium solar cells (12A, 12B) or two germanium-silicon solar cells (12A, 12B), deposited on said lower face and connected in series and also connected in parallel with the silicon solar cell (11A) through back contacts (23, 24) of the layer (11) of silicon.

2. Photovoltaic device according to claim 1, wherein the at least two germanium or germanium-silicon solar cells (12A, 12B) are germanium solar cells.

3. Photovoltaic device according to claim 1, wherein the at least two germanium or germanium-silicon solar cells (12A, 12B) are germanium-silicon solar cells.

4. Photovoltaic panel comprising a plurality of photovoltaic devices according to any of the preceding claims.

## Patentansprüche

1. Photovoltaikvorrichtung umfassend eine Vielzahl von Schichten (11, 12, 13), die dafür eingerichtet sind, Licht (L) in elektrische Energie umzuwandeln, wobei jede Schicht (11, 12, 13) mindestens eine Solarzelle (11A; 12A, 12B; 13A, 13B, 13C, 13D) umfasst, wobei jede Schicht (11, 12, 13) dafür eingerichtet ist, eine Bandlücke mit einer vorbestimmten Breite aufzuweisen, wobei die Breite der Bandlücke jeder Schicht (11, 12, 13) sich von der Breite der Bandlücke der anderen Schichten (11, 12, 13) unterscheidet, wobei mindestens eine der Schichten (12, 13) mindestens zwei Solarzellen (12A, 12B; 13A, 13B, 13C, 13D) umfasst, die in Reihe verbunden sind, wobei die in Reihe geschalteten Solarzellen Bandlücken mit gleicher Breite aufweisen; und wobei die Schichten (11, 12, 13) parallel miteinander verbunden sind, so dass die Spannung (U) auf jeder Schicht (11, 12, 13) gleich ist,
**dadurch gekennzeichnet, dass** mindestens eine der Schichten (11) eine Schicht aus Silizium ist, die eine Trägerschicht für die Vielzahl von Schichten (11, 12, 13) ist, wobei die Schicht (11) aus Silizium umfasst:
- mindestens eine Silizium-Solarzelle (11A) mit einer Oberseite und einer Unterseite, wobei die Schicht (11) aus Silizium Rückkontakte (23, 24) in der Unterseite aufweist, wobei eine weitere der Schichten (12) entweder zwei Germanium-Solarzellen (12A, 12B) oder zwei Germanium-Silizium-Solarzellen (12A, 12B) aufweist, die auf der Unterseite angeordnet und in Reihe geschaltet sind und auch durch Rückkontakte (23, 24) der Schicht (11) aus Silizium parallel zur Silizium-Solarzelle (11A) verbunden sind.

2. Photovoltaikvorrichtung nach Anspruch 1, wobei die mindestens zwei Germanium- oder Germanium-Silizium-Solarzellen (12A, 12B) Germanium-Solarzellen sind.

3. Photovoltaikvorrichtung nach Anspruch 1, wobei die mindestens zwei Germanium- oder Germanium-Silizium-Solarzellen (12A, 12B) Germanium-Silizium-Solarzellen sind.

4. Photovoltaikmodul, umfassend eine Vielzahl von Photovoltaikvorrichtungen gemäß einem der vorhergehenden Ansprüche.

## Revendications

1. Dispositif photovoltaïque comprenant une pluralité de couches (11, 12, 13) conçues pour transformer la lumière (L) en énergie électrique, chaque couche (11, 12, 13) comprenant au moins une cellule solaire (11A; 12A, 12B ; 13A, 13B, 13C, 13D), chaque couche (11, 12, 13) étant conçue de manière à présenter une bande interdite ayant une largeur prédéterminée, la largeur de la bande interdite de chaque couche (11, 12, 13) étant différente de la largeur de la bande interdite des autres couches (11, 12, 13), dans lequel au moins une desdites couches (12, 13) comprend au moins deux cellules solaires (12A, 12B ; 13A, 13B, 13C, 13D) connectées en série, lesdites cellules solaires connectées en série ayant des bandes interdites de même largeur ; et dans lequel les couches (11, 12, 13) sont reliées entre elles en parallèle, de sorte que la tension (U) sur chaque couche (11, 12, 13) est la même,
**caractérisé en ce qu'**au moins une desdites couches (11) est une couche de silicium qui est une couche de support pour la pluralité de couches (11, 12, 13), ladite couche (11) de silicium comprenant :
- au moins une cellule solaire au silicium (11A) ayant une face supérieure et une face inférieure, ladite couche (11) de silicium comprenant des contacts arrière (23, 24) dans la face inférieure, dans lequel une autre desdites couches (12) comprend deux cellules solaires au germanium (12A, 12B) ou deux cellules solaires au germanium-silicium (12A, 12B), déposées sur ladite face inférieure et connectées en série et également connectées en parallèle avec la cellule solaire au silicium (11A) par le biais des contacts arrière (23, 24) de la couche (11) de silicium.

2. Dispositif photovoltaïque selon la revendication 1, dans lequel les au moins deux cellules solaires au germanium ou au germanium-silicium (12A, 12B) sont des cellules solaires au germanium.

3. Dispositif photovoltaïque selon la revendication 1, dans lequel les au moins deux cellules solaires au germanium ou au germanium-silicium (12A, 12B) sont des cellules solaires au germanium-silicium.

4. Panneau photovoltaïque comprenant une pluralité de dispositifs photovoltaïques selon l'une quelconque des revendications précédentes.
